# EUROPEAN PATENT APPLICATION

(11) **EP 4 478 418 A1**
(43) Date of publication of application: **18.12.2024**
(21) Application number: 24166483.8
(22) Date of filing: 26.03.2024
(51) Int. Cl.: H01L 29/06, H01L 29/40, H01L 29/78, H01L 29/66

(54) **SEMICONDUCTOR DEVICE AND MANUFACTURING METHOD OF THE SAME**

(30) Priority: 12.06.2023 KR 20230075002
(71) Applicant: MagnaChip Semiconductor, Ltd., Chungcheongbuk-do 28581 (KR)
(72) Inventor: LEE, Jin, Seoul (KR); PARK, Chanho, Seoul (KR); KIM, Hohyun, Seoul (KR); HWANG, Daewon, Seoul (KR); KIM, Youngseok, Seoul (KR)
(74) Representative: Marks & Clerk LLP

(57) **Abstract**

A semiconductor device includes: a semiconductor substrate; an epitaxial layer disposed on the substrate; a plurality of trenches formed in the epitaxial layer; a shield insulating layer formed inside the plurality of trenches; a shield electrode surrounded by the shield insulating layer and disposed inside the plurality of trenches; an inter-electrode insulating layer formed on top of the shield insulating layer and the shield electrode; a gate insulating layer disposed on the inter-electrode insulating layer; a gate electrode disposed on the gate insulating layer; a body region formed on an upper portion of the epitaxial layer located between the plurality of trenches; a source region formed on the body region; an inter-layer insulating layer formed on the gate electrode and the source region; and a body contact region in contact with the source region and the body region.

## Description

### BACKGROUND

### 1. Field

The following description relates to a semiconductor device and a manufacturing method thereof, in particular, a semiconductor device having a trench MOSFET structure in which a shield electrode or a source electrode is formed at a lower portion of the trench and a gate electrode is formed at an upper portion thereof by applying a split gate trench structure, and a manufacturing method thereof.

### 2. Description of the Related Art

More and more electrical and electronic products require complex circuits and high performance technology. In order to reduce the power consumption and maximize efficiency of the products, a high performance electrical semiconductor device is required, and in particular, the demand for a power discrete trench MOSFET device is increasing rapidly.

A breakdown voltage and switching characteristics are important factors that determine the performance of a MOSFET device in a semiconductor device having a power trench MOSFET structure. In addition, reducing a high breakdown voltage and on-resistance is necessary to improve the characteristics of a semiconductor device.

As an example of related art, a power MOSFET using a triple poly structure allows a shield poly electrode to be formed within a trench and gate poly electrodes to be formed on both sides of an upper portion of the shield poly electrode. In this related art, it is not easy to ensure a stable breakdown voltage and an ON-OFF switching at the same time.

In the power MOSFET structure using the triple poly structure, a parasitic capacitance is generated between the shield poly electrode and the gate poly electrode because gate electrodes must be formed on both sides of the upper portion of the shield poly electrode, thereby the structure has a high parasitic capacitance value between the gate electrode and the source electrode. To reduce the parasitic capacitance value, an area of the gate electrode must be reduced or a thickness of an oxide formed between the gate electrode and the shield electrode must be secured. If the area of the gate electrode is reduced, it is difficult to secure a breakdown voltage above a certain level.

In addition, in order to improve the parasitic capacitance, a thickness of the insulating layer (oxide) disposed between the gate poly electrode and the shield poly electrode must be increased, and in this case, it is difficult to secure a small cell pitch because a trench width is increased because the thickness of the insulating layer must be increased. That is, it is difficult to secure many cells in a power trench MOSFET device, and thus it becomes difficult to increase cell density in a MOSFET device.

In addition, in a related art triple poly structure, the input capacitance (Ciss) value may also be increased because two gate poly electrodes must be formed on both sides of the top of the shield electrode. Here, the input capacitance means a capacitance that is charged when the device is turned on. As the input capacitance becomes smaller, the input switching speed becomes faster when the device is turned on. The input capacitance value is expressed as Cᵢₛₛ=C_{gs}+C_{gd}, but there is a problem in that C_{gs} (capacitance between the gate and source electrodes) is increased by having two gate poly electrodes.

As a result, the total amount of gate charges (Qg) required to charge the input capacitance (Ciss) increases, resulting in switching loss. When an amount of gate charges is large, it takes time to charge the power MOSFET to the required capacity to turn on the power MOSFET, so the switching loss increases. Therefore, it is necessary to improve the switching characteristics.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a semiconductor device includes a semiconductor substrate of a first conductivity type; an epitaxial layer of the first conductivity type disposed on the substrate; a plurality of trenches formed in the epitaxial layer; a shield insulating layer formed inside the plurality of trenches; a shield electrode surrounded by the shield insulating layer at a lower portion of the plurality of trenches; an inter-electrode insulating layer formed on top of the shield insulating layer and the shield electrode; a gate insulating layer disposed on the inter-electrode insulating layer; a gate electrode disposed on the gate insulating layer; a body region of a second conductive type formed on an upper portion of the epitaxial layer located between the plurality of trenches; a source region formed on the body region; an inter-layer insulating layer formed on the gate electrode and the source region; and a body contact region in contact with the source region and the body region. A location and a thickness of the gate electrode may be determined by a location and a thickness of the inter-layer insulating layer.

The location and the thickness of the inter-layer insulating layer may be determined by a depth at which the shield electrode is etched.

A ratio between a thickness of the inter-electrode insulating layer and the thickness of the gate electrode may be in a range from 1:1 to 1:10.

A ratio between a thickness of the inter-electrode insulating layer and a thickness of the shield electrode may be in a range from 1:3 to 1:15.

An upper surface of the body region may be disposed lower than an upper surface of the gate electrode.

A ratio between a thickness of the shield electrode and the thickness of the gate electrode may be in a range from 1:1 to 15:1.

The plurality of trenches may be formed to have an angle of inclination of a side of the trench between 85° and 90° relative to an upper inner surface of the plurality of trenches.

The shield insulating layer may be formed by a primary thermal oxidation or by a secondary chemical vapor deposition (CVD) after the primary thermal oxidation is performed.

The semiconductor device may further include: a metal layer formed over the body region, the source region, and the inter-layer insulating layer.

A ratio between a thickness of the inter-electrode insulating layer formed in a trench and the thickness of the gate electrode ranges from 1:1.2 to 1:3.

In another general aspect, a method for manufacturing a semiconductor device includes: forming an epitaxial layer of a first conductivity type on a substrate of the first conductivity type; forming a plurality of trenches in the epitaxial layer; forming a shield insulating layer inside the plurality of trenches; forming a shield electrode surrounded by the shield insulating layer at a lower portion of the plurality of trenches; forming an inter-electrode insulating layer over the shield insulating layer and the shield electrode inside the plurality of trenches; forming a gate insulating layer on the inter-electrode insulating layer disposed inside the plurality of trenches; forming a gate electrode on the gate insulating layer; forming a body region of a second conductivity type on an upper portion of the epitaxial layer between the plurality of trenches; forming a source region on the body region; forming an inter-layer insulating layer on the gate electrode and the source region; and forming a body contact region in the body region. A location and a thickness of the gate electrode may be determined by a location and a thickness of the inter-layer insulating layer.

The forming of the inter-electrode insulating layer may include determining the location and the thickness of the inter-layer insulating layer by a depth at which the shield electrode is etched.

The forming of the epitaxial layer may include: forming a lower epitaxial layer on the substrate, and forming an upper epitaxial layer on the lower epitaxial layer. A dopant concentration of the lower epitaxial layer is higher than a dopant concentration of the upper epitaxial layer.

The forming of the plurality of trenches may further include: forming the epitaxial layer, forming a mask on the epitaxial layer, and performing a trench etching on the epitaxial layer to form a trench, and forming an angle of inclination of a side of the trench between 85° and 90° relative to an upper inner surface of the trench.

The forming of the plurality of trenches may further include forming a sacrificial oxide layer to recover damage on a sidewall or uneven region of the epitaxial layer that occurred during an etching to form the plurality of trenches.

The forming of the shield insulating layer may further include forming the shield insulating layer by a primary thermal oxidation or by a secondary chemical vapor deposition (CVD) after the primary thermal oxidation is performed.

The forming of the shield electrode may further include: forming the shield electrode by depositing a shield poly inside the shield insulating layer on an upper surface of the shield insulating layer, etching the shield poly deposited on the upper surface of the shield insulating layer to a height of an upper surface of a trench via chemical mechanical polishing (CMP) or to a height of an upper surface of the epitaxial layer via a blanket etching, and etching the shield poly etched to the height of the upper surface of the trench or to the height of the upper surface of the epitaxial layer to a height at which the inter-electrode insulating layer is formed.

The forming of the shield electrode may further include etching a portion of a side surface of the shield insulating layer to increase a width of an opening in the shield insulating layer disposed on a side of the shield electrode.

The forming of the inter-electrode insulating layer may further include: depositing a poly oxide on an upper surface of the shield insulating layer by performing a CVD on the shield electrode, etching an upper surface of the epitaxial layer by performing a CMP, a blanket etching, or a combination of the CMP and the blanket etching, and performing a dry etching, a wet etching, or a combination of the dry etching and the wet etching to an upper surface and a sidewall of the inter-electrode insulating layer such that the inter-electrode insulating layer etched to the upper surface of the epitaxial layer is formed in a trench.

The forming of the gate electrode may further include: depositing a gate poly on the shield insulating layer and the gate insulating layer formed on an upper surface of the epitaxial layer, performing a CMP on the gate poly deposited on the upper surface of the epitaxial layer to the upper surface of the epitaxial layer, and performing a recess etching to the gate poly to which the CMP is performed so that a height of the gate poly is less than a height of the upper surface of the epitaxial layer.

The performing of the recess etching may include etching the gate poly from the upper surface of the epitaxial layer to an etch thickness of 500 Å to 5000 Å.

The forming of the body region may further include: forming the body region to have a maximum thickness on an upper surface of the epitaxial layer equal to a depth of the gate electrode formed on an upper surface of the inter-electrode insulating layer.

The method for manufacturing a semiconductor device may further include forming a metal layer over the body region, the source region, and the inter-layer insulating layer.

According to an example of the present disclosure, a power trench MOSFET device may implement a small cell pitch by forming a shield electrode in a lower portion of the trench and a gate electrode in an upper portion of the trench through application of a split gate trench structure, thereby obtaining an improved density of a MOSFET device.

Further, by optimizing the thickness of the gate electrode, fast switching characteristics can be realized by reducing the input capacitance characteristics and the total amount of gate charges (Qg).

Further, by obtaining an inter-electrode insulating layer (inter-poly oxide) having an optimized thickness formed between the shield poly electrode and the gate electrode, the switching characteristics of the device including input capacitance and parasitic capacitance can be improved without reducing the breakdown voltage.

Further, it is possible to secure a desired input capacitance (Ciss) value, a feedback capacitance (Crss) value, and a breakdown voltage value by applying a method for manufacturing a device that adjusts a thickness of an inter-electrode insulating layer, a depth of a body junction, and a thickness of a gate poly.

Furthermore, it is possible to secure a desired input capacitance (Ciss) value, a feedback capacitance (Crss) value, and a breakdown voltage value by optimizing thickness ratios of the shield electrode, the gate electrode and the inter-electrode insulating layer.

The effects that may be obtained by the present disclosure are not limited to the aforementioned effects described above, and other technical effects not described above will be apparent to one having ordinary skill in the art to which the present disclosure pertains from the following description.

### Brief Description of Drawings

FIG. 1A is a diagram illustrating a structure of a semiconductor device according to an example of the present disclosure.
FIG. 1B illustrates thicknesses of components of a semiconductor device according to an example of the present disclosure.
FIG. 2 illustrates a structure of a trench formed inside an epitaxial layer according to an example of the present disclosure.
FIG. 3 illustrates a structure of a shield insulating layer according to an example of the present disclosure.
FIGS. 4A to 4E illustrate a process for forming a shield electrode according to an example of the present disclosure.
FIGS. 5A to 5C illustrate a process for forming an inter-electrode insulating layer according to an example of the present disclosure.
FIG. 6 illustrates a structure of a gate insulating layer according to an example of the present disclosure.
FIGS. 7A to 7C illustrate a process for forming a gate electrode according to an example of the present disclosure.
FIG. 8 illustrates a process to form a body region, a source region, and an inter-layer insulating layer according to an example of the present disclosure.
FIG. 9 illustrates a structure of a metal layer according to an example of the present disclosure.
Other features and aspects will be apparent from the following detailed description, the drawings, and the claims.

### Detailed Description

The features, advantages, and method for accomplishment of the present disclosure will be more apparent from referring to the following detailed examples described as well as the accompanying drawings. However, the present disclosure is not limited to the example to be disclosed below and is implemented in different and various forms. The examples bring about the complete disclosure of the present disclosure and are provided to make those skilled in the art fully understand the scope of the present invention. The present disclosure is just defined by the scope of the appended claims. The same or similar reference numerals throughout the disclosure may be used for the same or similar components.

What one component is referred to as being "connected to" or "coupled to" another component includes both a case where one component is directly connected or coupled to another component and a case where a further another component is interposed between them. Meanwhile, what one component is referred to as being "directly connected to" or "directly coupled to" another component indicates that a further another component is not interposed between them. The term "and/or" includes each of the mentioned items and one or more all of combinations thereof.

Terms used in the present specification are provided for description of only specific examples of the present disclosure, and not intended to be limiting. In the present specification, an expression of a singular form includes the expression of plural form thereof if not specifically stated. The terms "comprises" and/or "comprising" used in the specification is intended to specify characteristics, numbers, steps, operations, components, parts or any combination thereof which are mentioned in the specification, and intended not to exclude the existence or addition of at least one another characteristics, numbers, steps, operations, components, parts or any combination thereof.

While terms such as the first and the second, etc., can be used to describe various components, the components are not limited by the terms mentioned above. The terms are used only for distinguishing between one component and other components.

Therefore, the first component to be described below may be the second component within the spirit of the present invention. Unless differently defined, all terms used herein including technical and scientific terms have the same meaning as commonly understood by one of ordinary skill in the art to which the present invention belongs. Also, commonly used terms defined in the dictionary should not be ideally or excessively construed as long as the terms are not clearly and specifically defined in the present application.

A term "part" or "module" used in the examples may mean software components or hardware components such as a field programmable gate array (FPGA), an application specific integrated circuit (ASIC). The "part" or "module" performs certain functions. However, the "part" or "module" is not meant to be limited to software or hardware. The "part" or "module" may be configured to be placed in an addressable storage medium or to restore one or more processors. Thus, for one example, the "part" or "module" may include components such as software components, object-oriented software components, class components, and task components, and may include processes, functions, attributes, procedures, subroutines, segments of a program code, drivers, firmware, microcode, circuits, data, databases, data structures, tables, arrays, and variables. Components and functions provided in the "part" or "module" may be combined with a smaller number of components and "parts" or "modules" or may be further divided into additional components and "parts" or "modules".

Methods or algorithm steps described relative to some examples of the present invention may be directly implemented by hardware and software modules that are executed by a processor or may be directly implemented by a combination thereof. The software module may be resident on a RAM, a flash memory, a ROM, an EPROM, an EEPROM, a resistor, a hard disk, a removable disk, a CD-ROM, or any other type of record medium known to those skilled in the art. An exemplary record medium is coupled to a processor and the processor can read information from the record medium and can record the information in a storage medium. In another way, the record medium may be integrally formed with the processor. The processor and the record medium may be resident within an application specific integrated circuit (ASIC). The ASIC may be resident within a user's terminal.

Hereinafter, a detailed description will be given as to the examples of the present invention with reference to the accompanying drawings in order for those skilled in the art to embody the present invention with ease. But the present invention is susceptible to variations and modifications and not limited to the examples described herein.

Hereinafter, a structure of a semiconductor device according to an example of the present disclosure will be described with reference to the accompanying drawings.

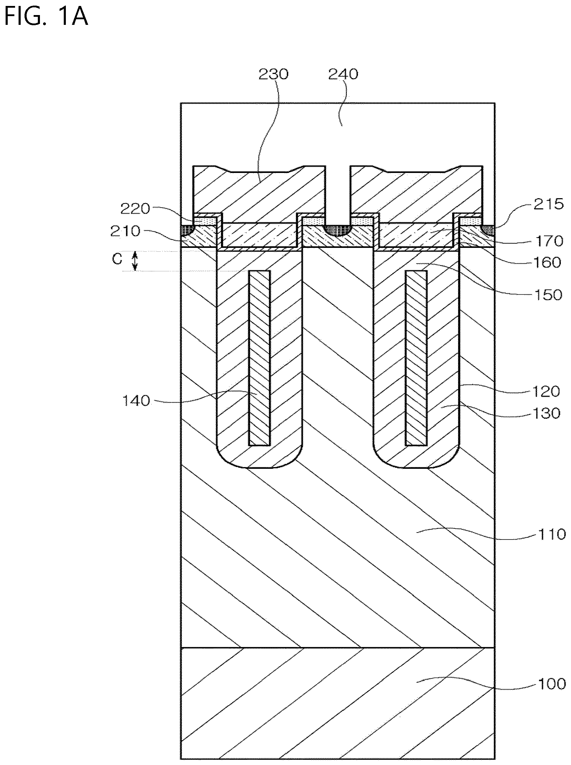

FIG. 1A illustrates a structure of a semiconductor device according to an example of the present disclosure.

Referring to FIG. 1A, a semiconductor substrate 100 of a semiconductor device according to an example of the present disclosure may have a first conductivity type. An epitaxial layer 110 may be formed on the semiconductor substrate 100.

The first conductivity type of the substrate 100 may have a dopant concentration that is higher than a dopant concentration of the epitaxial layer 110.

The epitaxial layer 110 may have the same first conductivity type as the semiconductor substrate 100 having the first conductivity type. The epitaxial layer 110 may include at least two or more layers by performing a multiple epi-forming process, wherein a lower epitaxial layer (not shown) may be formed on the substrate 100, and an upper epitaxial layer (not shown) may be formed on the lower epitaxial layer.

In the lower epitaxial layer, the dopant of the first conductivity type in the substrate 100 may be dispersed into the lower epitaxial layer by a thermal process performed in a subsequent process, so that the concentration of the lower epitaxial layer increases and the resistivity value decreases. In the upper epitaxial layer, since the dispersion of the dopant of the first conductivity type is relatively small, the concentration of the dopant of the first conductivity type may be lower than that of the lower epitaxial layer, and thus the resistivity of the epitaxial layer may be relatively high.

In this way, the resistivity formed in the epitaxial layer 110 of the drift layer is reduced as a whole, and a low on-resistance (Rdson) between the drain and the source can be realized. The epitaxial layer 110 may have a thickness of 2 µm to 15 µm, and may be formed to have a thickness of less than three times the depth of the trench 120 described later.

A shield insulating layer 130 may be formed inside the plurality of trenches 120. The shield insulating layer 130 may be formed via a primary thermal oxidation process and a secondary deposition process.

A shield electrode 140 may be formed in the lower portion of the plurality of trenches 120 surrounded by the shield insulating layer 130. The shield electrode 140 may be formed by performing a shield poly deposition process on the shield insulating layer 130.

An inter-electrode insulating layer 150 may be formed on the shield insulating layer 130 and the shield electrode 140 in the plurality of trenches 120. By adjusting the area of the inter-electrode insulating layer 150, it may be possible to adjust the input capacitance value and the total amount of gate charge (Qq) required to drive the input capacitance value. The inter-electrode insulating layer 150 may be referred to as an inter-poly dielectric layer, an inter-poly oxide layer, or an inter-electrode insulating layer made of an oxide, or the like.

A gate insulating layer 160 may be formed and disposed on the inter-electrode insulating layer inside the plurality of trenches. The gate insulating layer 160 may be formed on an upper surface of the etched inter-electrode insulating layer 150 inside the trenches, on the inner wall of the trench 120, and on a portion of an upper surface of the epitaxial layer 110 via a deposition process.

The gate electrode 170 may be formed and disposed on the gate insulating layer 160.

The gate electrode 170 may be formed by recess etching the gate poly from an upper surface of the epitaxial layer 110 into the interior of the trench 120. By the recess etching process to adjust the thickness A of the gate electrode 170, the input capacitance value and the total amount of gate charges (Qq) required to drive the input capacitance value may be adjusted.

The gate electrode 170 disposed inside the trench 120 may be referred to as an upper electrode, and the shield electrode 140 may be referred to as a lower electrode.

The body region 210 may be formed including a surface on an upper portion of the epitaxial layer 110 between the plurality of trenches 120.

Depending on the depth at which the body region 210 is formed, the on-resistance (Ron) and capacitance values may be adjusted, so that the depth of the body region 210 may vary depending on the intended use of the device.

A source region 220 may be formed on the body region 210.

An inter-layer insulating layer 230 may be formed on an upper surface of the gate electrode 170 and a portion of an upper surface of the source region 220.

A body contact region 215 may be in contact with the source region 220 and the body region 210. The body contact region 215 may be formed within the body region 210, which is formed between the plurality of trenches 120.

A metal layer 240 may be formed on the body region 210, the source region 220, and the inter-layer insulating layer 230. The metal layer 240 may be referred to as a source electrode electrically connected to the source region 220.

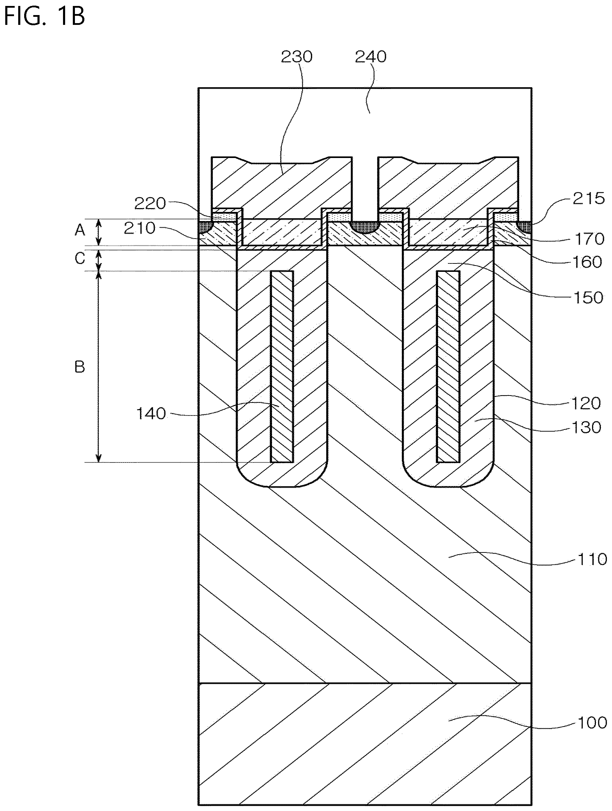

FIG. 1B illustrates thicknesses of components of a semiconductor device according to an example of the present disclosure.

Referring to FIG. 1B, 'A' indicated in the drawing represents a thickness of the gate electrode 170, 'B' represents a thickness of the shield electrode 140, and 'C' represents a thickness of the inter-electrode insulating layer 150.

Further, a ratio between the thickness 'B' of the shield electrode 140 and the thickness 'A' of the gate electrode may be expressed as 1:1 to 15:1.

By adjusting the thickness of the gate electrode 170, the area of the inter-layer insulating layer 230 formed on the gate electrode 170 may be adjusted. Also, by adjusting the thickness of the gate electrode 170, the area of the inter-layer insulating layer 230 formed on the gate electrode 170 may be adjusted, and the capacitance value may be changed accordingly. Furthermore, by adjusting the thicknesses of the gate electrode 170 and the shield electrode 140, the MOSFET voltage (guarantee withstand voltage) may be adjusted. As the thickness of the shield electrode 140 increases relative to the thickness of the gate electrode 170, a power MOSFET device having a high guarantee withstand voltage can be implemented.

A ratio between the thickness ('C') of the inter-electrode insulating layer 150 and the thickness (`A') of the gate electrode 170 may be expressed as 1:1 to 1:10.

Further, a ratio between the thickness ('C') of the inter-electrode insulating layer 150 and the thickness (`B') of the shield electrode 140 may be expressed as 1:3 to 1:15.

The present disclosure may have a characteristic that a capacitance value suitable for the device characteristics can be adjusted by adjusting the above-described thickness.

Hereinafter, a method for manufacturing the semiconductor device according to an example of the present disclosure will be described.

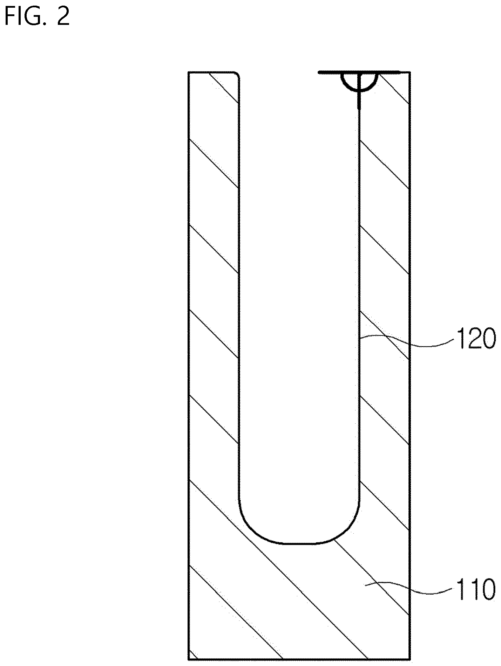

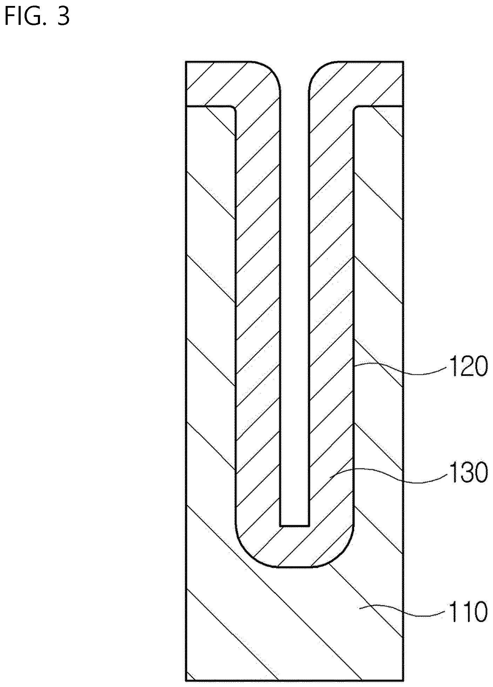

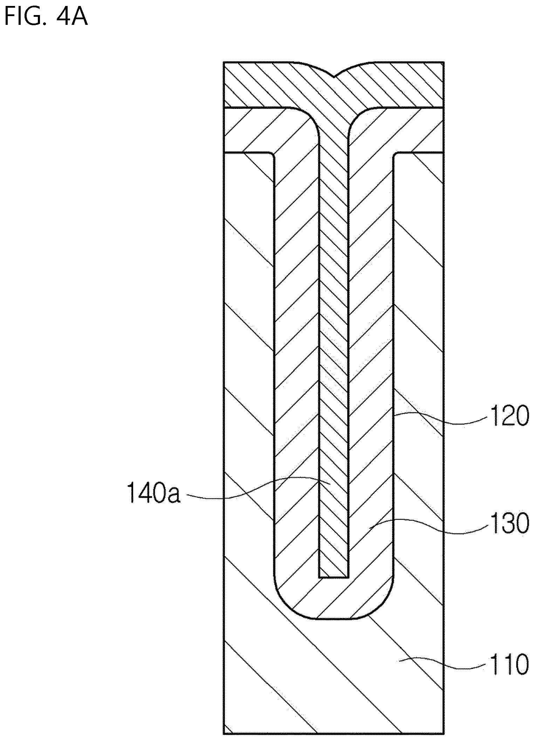

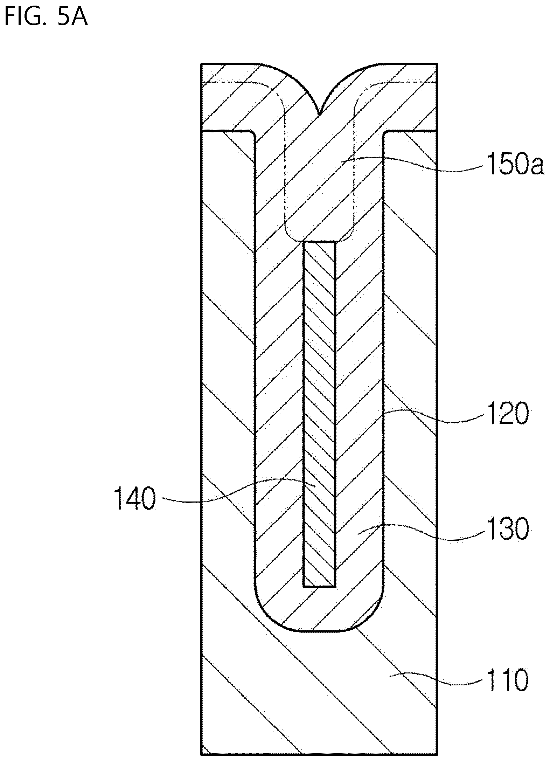

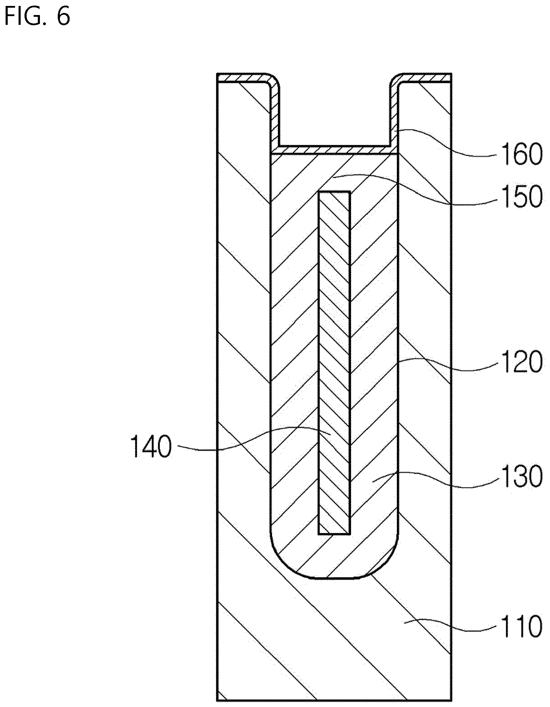

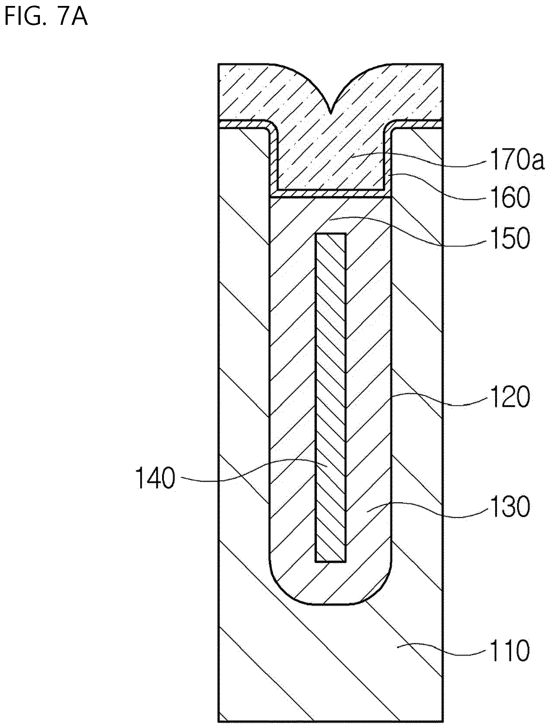

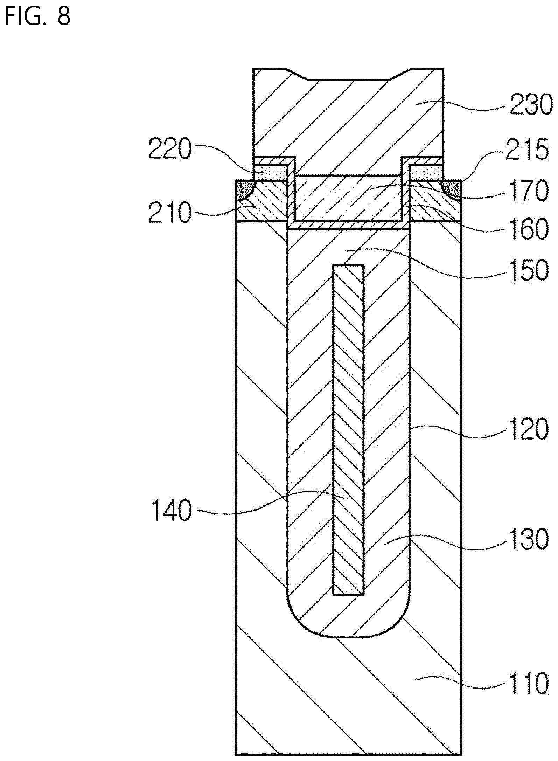

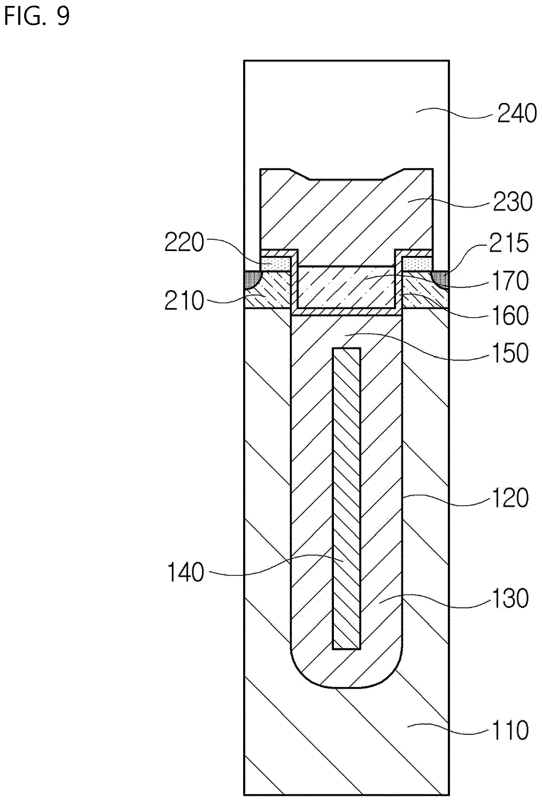

FIG. 2 illustrates a structure of a trench formed inside an epitaxial layer according to an example of the present disclosure, FIG. 3 illustrates a structure of a shield insulating layer according to an example of the present disclosure, FIGS. 4A to 4E are diagrams illustrate a process for forming a shield electrode according to an example of the present disclosure, FIGS. 5A to 5C illustrate a process for forming an inter-electrode insulating layer according to an example of the present disclosure, FIG. 6 illustrates a structure of a gate insulating layer according to an example of the present disclosure, FIGS. 7A to 7C illustrate a process for forming a gate electrode according to an example of the present disclosure, FIG. 8 illustrates a process to form a body region, a source region, and an inter-layer insulating layer according to an example of the present disclosure, and FIG. 9 illustrates a structure of a metal layer according to an example of the present disclosure.

Referring to FIG. 2, the epitaxial layer 110 may be formed on the substrate 100. The semiconductor substrate 100 may be formed of a first conductivity type. The epitaxial layer 110 may be formed of the same first conductivity type as the substrate 100. The epitaxial layer 110 may be configured to have at least two or more layers, that is, may comprise multiple epitaxial layers. A lower epitaxial layer (not shown) may be formed on the substrate 100, and an upper epitaxial layer (not shown) may be formed on the lower epitaxial layer. In the lower epitaxial layer, as the dopant of the first conductivity type inside the substrate 100 is dispersed into the lower epitaxial layer by a thermal process to be performed in a subsequent process, its resistivity value may be reduced by an increase in the concentration of the lower epitaxial layer.

In the upper epitaxial layer, the resistivity value of the epitaxial layer may be higher because the dispersion of the first conductivity type dopant in the upper epitaxial layer is relatively reduced, and the concentration of the first conductivity type dopant is relatively low. In this way, the resistivity of the epitaxial layer 100 of the drift layer may be reduced, and a low on-resistance (Rdson) between the drain and the source may be realized. The epitaxial layer 110 may have a thickness of 2 µm to 15 µm, and may have a thickness of no more than three times the depth of the trench 120.

Referring to FIG. 2, a plurality of trenches 120 may be formed inside the epitaxial layer 110. The plurality of trenches 120 may be formed by performing a mask process and an etching process after forming the epitaxial layer 110. The plurality of trenches 120 may be formed such that an inclination angle of a side of the trench is 85° to 90° relative to an upper inner surface of the trench when etched, and the trench may be formed in a downward direction from the upper surface of the trench when etched. Further, the plurality of trenches 120 may be formed to have an angle of inclination of the trench sidewalls with respect to the upper outer surface of the trench of 90°to 95°, i.e., the width the lower surface of the trench may be formed to be narrower than or equal to the width of the upper surface of the trench.

This is to optimize characteristics such as step coverage, cell pitch, breakdown voltage, etc. of the gate electrode 170 and the poly shield formed inside the trench 120.

When etched, the trench 120 may be formed to have a U-shape or a V-shape, depending on the angle at which the trench 120 is etched.

The substrate 100 and the epitaxial layer 110 may be formed of silicon and silicon carbide.

After etching the trench, the step of forming a sacrificial oxide layer (not shown) on the sidewall of the trench 120 may be further included. The sacrificial oxide layer may be formed on the sidewall of the trench 120, which is etched on an upper portion of the inside of the epitaxial layer 110. The sacrificial oxide layer may be used to repair damage or uneven areas formed on the sidewall of the epitaxial layer 110 during etching of the trench 120. The sacrificial oxide layer may be formed thinly to have a thickness of 100Å to 1500Å by performing a thermal process at a temperature between 900°C and 1200°C. The sacrificial oxide layer may be removed from the epitaxial layer 110 after repairing damage or irregularities in the sidewall formed during etching of the trench 120.

Referring to FIG. 3, the shield insulating layer 130 may be formed inside the plurality of trenches 120. The shield insulating layer 130 may be formed via deposition by a primary thermal oxidation process. The shield insulating layer 130 may be deposited by the primary thermal oxidation process to a thickness of 1000Å to 7000Å. In another example, the shield insulating layer 130 may be formed by further performing a secondary chemical vapor deposition (CVD) process after the primary thermal oxidation layer process.

The secondary chemical vapor deposition (CVD) process may be formed by depositing an insulating layer with a thickness of 500Å to 5000Å. In this case, the primary thermal oxidation layer may act as a buffer layer. The shield insulating layer 130 may be formed only by deposition of the primary thermal oxidation layer, or by a combination of the primary and secondary insulating layer deposition processes.

The secondary CVD process may be performed by sub-atmospheric pressure CVD (SACVD), plasma enhanced CVD (PECVD), high density plasma CVD (HDPCVD), or the like.

The shield insulating layer 130 may be formed as a silicon oxide layer by the primary thermal oxidation process, and may be formed as an oxide layer or a nitride layer by the secondary process, or may be formed as a deposited structure with an oxide layer and a nitride layer deposited, according to other examples.

Referring to FIGS. 4A to 4D, the shield electrode 140 may be formed by depositing and etching the shield poly 140a to 140d.

Referring to FIG. 4A, after forming the shield insulating layer 130, the shield poly 140a deposition process may be performed on the shield insulating layer 130. The thickness of the shield poly 140a deposited on the shield insulating layer 130 may be from 0.3 µm to 8 µm.

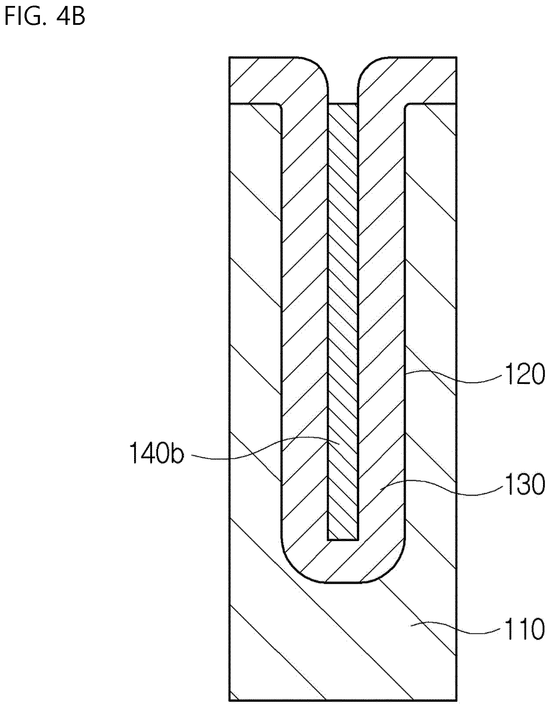

Referring to FIG. 4B, a portion of the shield poly deposited on the shield insulating layer 130 may be removed by etching. After removing a portion of the shield poly from the upper surface of the trench 120 by a CMP process, the blanket etch process may remove the shield poly so that only a portion of the shield poly 140b remains on the upper surface of the epitaxial layer 110.

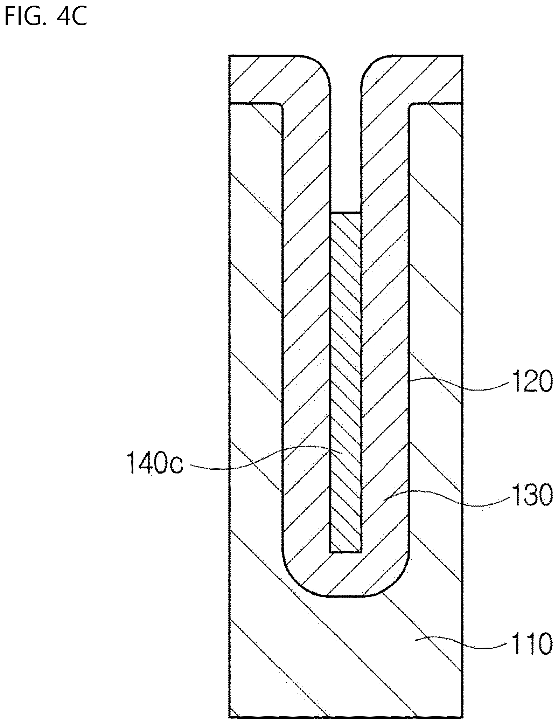

Referring to FIG. 4C, a portion of the shield poly 140c inside the trench may be removed by further etching the shield poly 140c etched on the upper surface of the epitaxial layer 110. the depth to which a portion of the shield poly 140c is etched away inside the trench 120 determines the thickness of the inter-electrode insulating layer 150, which will be described later. The etched shield poly 140c functions as the shield electrode 140.

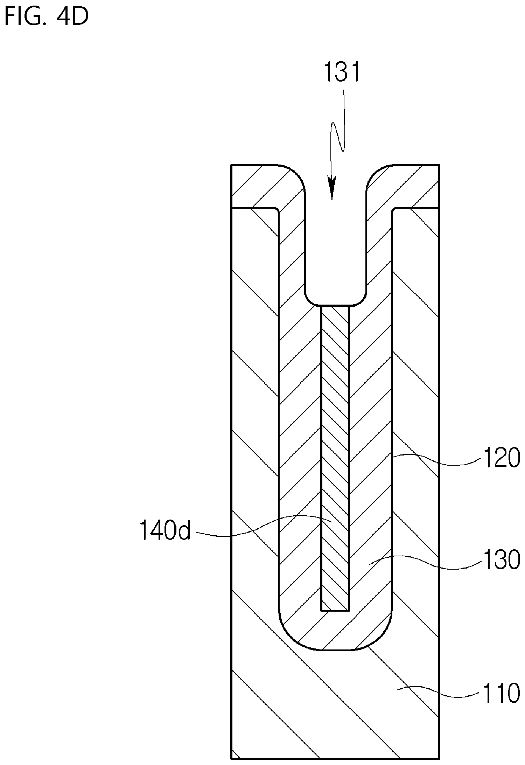

Referring to FIG. 4D, a portion of the shield insulating layer 130 formed on the sidewall of the trench in an upper portion of the shield poly 140d may be etched. By etching the portion of the shield insulating layer 130, an opening 131 in the shield insulating layer 130 may be widened. In this way, the inter-electrode insulating layer 150 to be described later may be easily deposited on the interior of the trench 120 and the shield insulating layer 130. Here, the etching process may be referred to as a partial etching process.

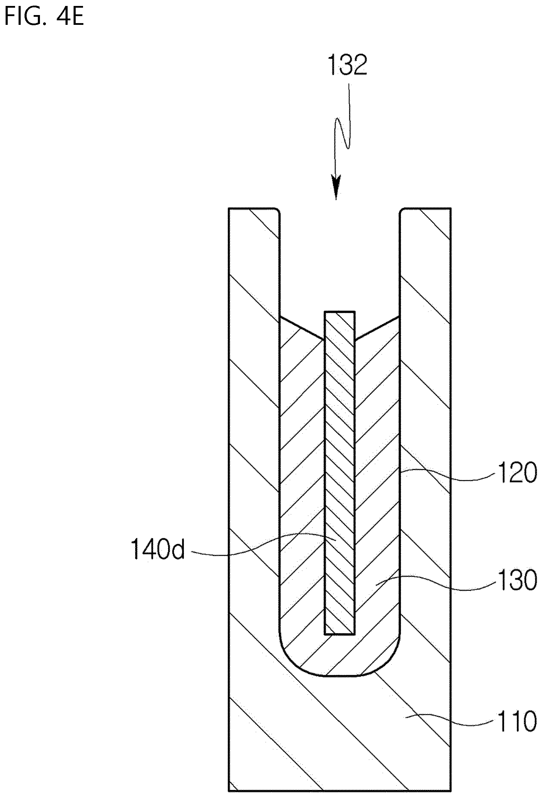

Referring to FIG. 4E, according to another example different from the process described with reference to FIG. 4D, the entire upper surface of the shield insulating layer 130 formed on the sidewall of the trench in the upper portion of the shield poly 140d may be etched. By etching the entire upper surface of the shield insulating layer 130, the opening 132 in the shield insulating layer 130 may be wider than the width of the opening 131 formed in FIG. 4D. The shield insulating layer 130 may be etched deeper than the upper surface of the shield poly 140c. In this way, the inter-electrode insulating layer 150, which will be described layer, may be easily deposited on the interior of the trench 120 and the shield insulating layer 130.

When performing the etching, the etching may be performed by a wet etching or dry etching method.

The etching process may be performed by a dry etching method, a wet etching method, or a combination thereof.

Referring to FIGS. 5A to 5C, the inter-electrode insulating layer 150 may be formed by depositing the inter-electrode insulating layer 150a to 150c on the shield insulating layer 130 and the shield electrode 140 inside the plurality of trenches 120, and then etching.

Referring to FIG. 5A, the inter-electrode insulating layer 150a may be deposited on the shield insulating layer 130 and the shield electrode 140 after performing the partial etching of FIG. 4D. The inter-electrode insulating layer 150a may be deposited by a CVD process. Alternatively, the inter-electrode insulating layer 150a may be deposited by sub-atmospheric pressure CVD among CVD processes. The inter-electrode insulating layer 150a may be deposited on an upper surface of the shield insulating layer 130 with a thickness of 1000Å to 15000Å.

Further, the deposition by CVD may be performed by a plasma enhanced CVD process, a high density plasma CVD (HDPCVD) process, etc.

Each of the shield insulating layer 130 and the inter-electrode insulating layer 150 may be formed from an insulating layer made of the same material or an insulating layer made of different materials.

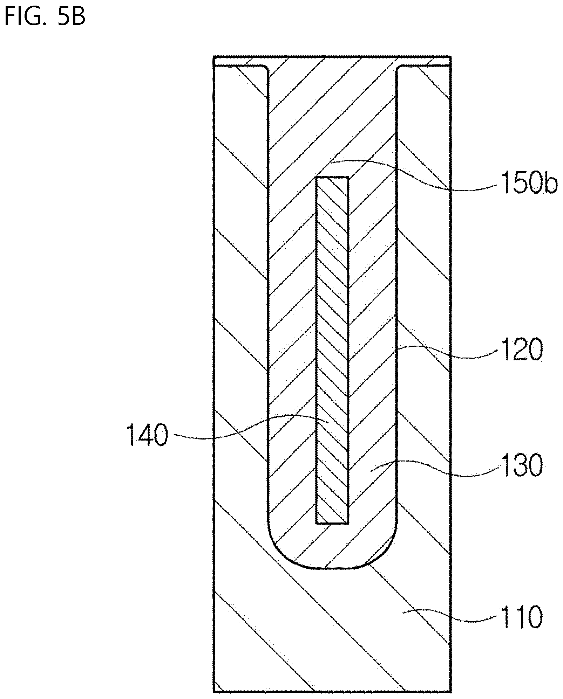

Referring to FIG. 5B, the CMP process and the blanket etching process may be performed on a portion of the shield insulating layer 130 and a portion of the inter-electrode insulating layer 150b deposited on the upper surface of the epitaxial layer 110, such that a portion of the shield insulating layer 130 and a portion of the inter-electrode insulating layer 150b remain on the upper surface of the epitaxial layer 110.

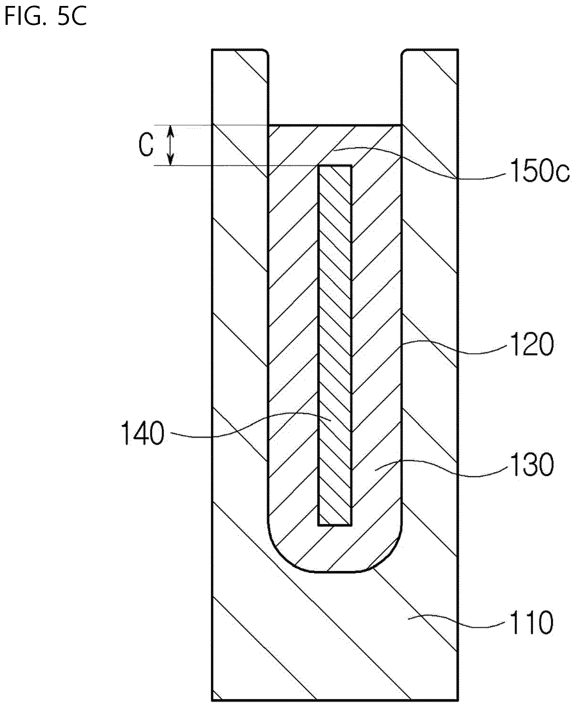

Referring to FIG. 5C, by further etching the left shield insulating layer 130 and the inter-electrode insulating layer 150c, the thickness (C) of the inter-electrode insulating layer 150 inside the trench may be adjusted. A portion of the shield insulating layer 130 and an upper portion of the inter-electrode insulating layer 150c inside the trench 120 formed by the further etching process may be removed by a dry etching method, a wet etching method, or a combination of these methods. By removing a portion of an upper portion of the shield insulating layer 130 and the inter-electrode insulating layer 150c, the inter-electrode insulating layer 150 may be formed inside the trench 120.

The inter-electrode insulating layer 150 formed on an upper surface of the shield electrode 140 inside the trench 120 may have a thickness of 1000 Å to 8000 Å. By adjusting the thickness C of the inter-electrode insulating layer 150 through this etching process, the area of the inter-electrode insulating layer 150 may be adjusted. By adjusting the area of the inter-electrode insulating layer 150, the target input capacitance value and the total amount of gate charges (Qq) required to drive the input capacitance value may be adjusted.

Referring to FIG. 6, the gate insulating layer 160 disposed on the inter-electrode insulating layer 150 inside the plurality of trenches 120 may be formed. The gate insulating layer 160 may be formed on the upper surface of the inter-electrode insulating layer 150 inside the trench 120, an inner wall of the trench 120, and an upper surface of the epitaxial layer 110, or the like, via a deposition process. The thickness of the gate insulating layer 160 may be formed in a range from about 100Å to 1000Å.

Referring to FIGS. 7A to 7C, gate poly 170a to 170c may be deposited and etched on the gate insulating layer 160.

Referring to FIG. 7A, the gate poly 170a may be deposited on the gate insulating layer 160. The gate poly 170a may be deposited from the interior of the trench 120 onto the upper surface of the epitaxial layer 110.

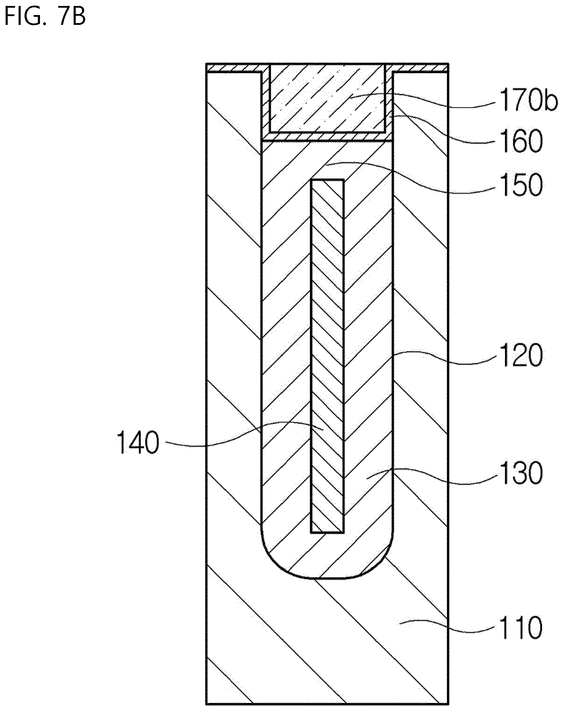

Referring to FIG. 7B, the gate poly 170b deposited over the upper surface of the epitaxial layer 110 may be removed to the upper surface of the epitaxial layer 110. A portion of the gate insulating layer 160 deposited on the upper surface of the epitaxial layer 110 may remain.

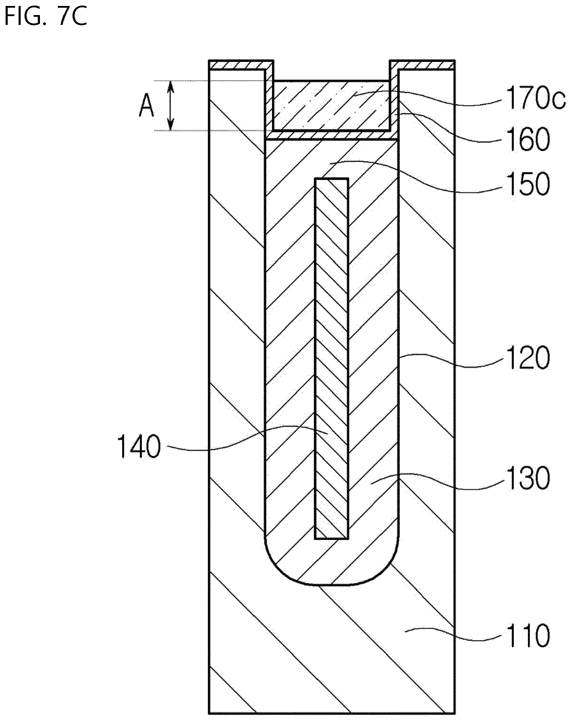

Referring to FIG. 7C, the gate poly 170c may be recess etched from the upper surface of the epitaxial layer 110 into the interior of the trench 120. By forming the gate poly into the gate electrode 170 through recess etching, the thickness A of the gate electrode 170 may be adjusted. The thickness at which the gate poly 170c is recess etched onto the upper surface of the epitaxial layer 110 may range from 500 Å to 5000 Å. After the recess etching, the gate electrode 170 may have a thickness of 0.3 µm to 1 µm. By adjusting the thickness, A of the gate electrode 170 through the above process, the target input capacitance value and the total amount of gate charges (Qq) required to drive the input capacitance value may be adjusted.

Referring to FIG. 8, the body region 210 may be formed on the upper surface of the epitaxial layer 110 between the plurality of trenches 120. Here, the substrate 100 and the epitaxial layer 110 may have a first conductivity type, and the body region 210 may have an opposite second conductivity type. The body region 210 may be formed by a single implant or a plurality of implants. During the plurality of implantations, the process may be performed by dividing it into a first body region formation and a second body region formation, and the concentrations of each may be adjusted differently.

Further, the upper surface of the body region 210 may be disposed lower than the upper surface of the gate electrode 170.

While ions are implanted in the body region 210, impurities such as boron (B), boron difluoride (BF2), and the like may be used for ion implantation.

Depending on the application of the power semiconductor devices, the depth of the body region 210 may be formed at various depths because the on-resistance (Ron), input capacitance (Ciss) value, and feedback capacitance (Crss) value may be adjusted depending on the depth at which the body region is formed.

After forming the body region 210, a source pattern process may be performed to form the source region 220. To prevent the source region 220 from being formed on a termination region or the like within the body region 210 except for the active region in which the source region 220 is to be formed, a source patterning process may be performed. After performing the source patterning process, the source region 220 may be formed. The source region 220 may be formed on the body region 210. The source region 220 may have a first conductivity type opposite to the body region 210. After forming the source region 220, a source pattern mask used in the source patterning process may be removed.

When forming the source region 220, impurities such as arsenic, phosphorus, or the like may be used. After forming the source region 220, an inter-layer insulating layer 230 may be formed. The inter-layer insulating layer 230 may be an inter-layer dielectric (ILD) layer. The inter-layer insulating layer 230 may be formed on an upper surface of the gate electrode 170 and an upper surface of the source region 220. The inter-layer insulating layer 230 may be formed by a process that forms a layer of tetraethyl orthosilicate (TEOS), borophosphorsilicate glass (BPSG), or the like. When the inter-layer insulating layer 230 is formed as a TEOS layer, the thickness may be from about 1000Å to 5000Å. Alternatively, when the inter-layer insulating layer 230 is formed as a BPSG layer, the thickness may be from about 1000Å to 5000Å.

A body contact region 215 may be formed. The body contact region 215 may be formed in the body region 210 formed between the plurality of trenches 120. The body contact region 215 may be formed by etching the inter-layer insulating layer 230. The body contact region 215 may be formed via a contact recess etching process. The metal layer 240 may be deposited to be disposed in the body contact region 215 formed between the inter-layer insulating layers 230.

The body contact region 215 is ion implanted with a high concentration of impurities of the second conductivity type, which is higher than the concentration in the body region 210.

Referring to FIG. 9, a metal layer 240 may be formed. The metal layer 240 may be formed on the body region 210, the source region 220, and the inter-layer insulating layer 230. The metal layer 240 may be formed by covering the body region 210, the source region 220, and the inter-layer insulating layer 230. Further, the metal layer 240 may be deposited so as to be disposed on the body contact region 215 formed between the inter-layer insulating layers 230 described above. The metal layer 240 may be formed via a CMP process after performing a deposition process with a uniform thickness.

The metal layer 240 may be formed from a metal such as aluminum (Al), tungsten (W), or copper (Cu).

A passivation layer (not shown) may be formed on the metal layer 240 to protect the device.

The metal layer 240 may be referred to as a source electrode.

As described above, a manufacturing method of a semiconductor device according to an example of the present disclosure may realize a small cell pitch by applying the split gate trench structure to form shield electrode 140 in the lower part of the trench 120 and a gate electrode 170 over the shield electrode 140, and may realize fast switching characteristics by minimizing the thickness of the gate electrode 170 to reduce the input capacitance value and the total amount of gate charges (Qq) required to drive the input capacitance(Ciss) value.

Furthermore, it is an object of the present disclosure to obtain a low input capacitance (Ciss) value by forming an inter-electrode insulating layer 150 having a thickness suitable for the device characteristics between the shield electrode and the gate electrode through a shield poly recess process and an oxide formation process.

Although the present disclosure has been described with reference to the examples illustrated in the drawings, this is merely exemplary. It will be understood by those skilled in the art that various modifications and equivalent examples thereto may be implemented. Accordingly, the true technical protection scope of the present disclosure should be determined by the inventive concepts of the following claims.

## Claims

1. A semiconductor device, comprising:
a semiconductor substrate of a first conductivity type;
an epitaxial layer of the first conductivity type disposed on the substrate;
a plurality of trenches formed in the epitaxial layer;
a shield insulating layer formed inside the plurality of trenches;
a shield electrode surrounded by the shield insulating layer at a lower portion of the plurality of trenches;
an inter-electrode insulating layer formed on top of the shield insulating layer and the shield electrode;
a gate insulating layer disposed on the inter-electrode insulating layer;
a gate electrode disposed on the gate insulating layer;
a body region of a second conductive type formed on an upper portion of the epitaxial layer located between the plurality of trenches;
a source region formed on the body region;
an inter-layer insulating layer formed on the gate electrode and the source region; and
a body contact region in contact with the body region and the source region,
wherein a location and a thickness of the gate electrode are determined by a location and a thickness of the inter-layer insulating layer.

2. The semiconductor device of claim 1, wherein the location and the thickness of the inter-layer insulating layer are determined by a depth at which the shield electrode is etched.

3. The semiconductor device of claim 1, wherein an upper surface of the body region is disposed lower than an upper surface of the gate electrode.

4. The semiconductor device of claim 1, wherein the shield insulating layer is formed by a primary thermal oxidation or by a secondary chemical vapor deposition (CVD) after the primary thermal oxidation is performed.

5. A method for manufacturing a semiconductor device, the method comprising:
forming an epitaxial layer of a first conductivity type on a substrate of the first conductivity type;
forming a plurality of trenches in the epitaxial layer;
forming a shield insulating layer inside the plurality of trenches;
forming a shield electrode surrounded by the shield insulating layer at a lower portion of the plurality of trenches;
forming an inter-electrode insulating layer over the shield insulating layer and the shield electrode inside the plurality of trenches;
forming a gate insulating layer on the inter-electrode insulating layer disposed inside the plurality of trenches;
forming a gate electrode on the gate insulating layer;
forming a body region of a second conductivity type on an upper portion of the epitaxial layer between the plurality of trenches;
forming a source region on the body region;
forming an inter-layer insulating layer on the gate electrode and the source region; and
forming a body contact region in the body region,
wherein a location and a thickness of the gate electrode are determined by a location and a thickness of the inter-layer insulating layer.

6. The method for manufacturing a semiconductor device of claim 5, wherein the forming of the inter-electrode insulating layer comprises:
determining the location and the thickness of the inter-layer insulating layer by a depth at which the shield electrode is etched.

7. The method for manufacturing a semiconductor device of claim 5, wherein the forming of the epitaxial layer further comprises:
forming a lower epitaxial layer on the substrate; and
forming an upper epitaxial layer on the lower epitaxial layer, and
wherein a dopant concentration of the lower epitaxial layer is higher than a dopant concentration of the upper epitaxial layer.

8. The method for manufacturing a semiconductor device of claim 5, wherein the forming of the plurality of trenches further comprises:
forming the epitaxial layer, forming a mask on the epitaxial layer, and performing a trench etching on the epitaxial layer to form a trench, and forming an angle of inclination of a side of the trench between 85° and 90° relative to an upper inner surface of the trench.

9. The method for manufacturing a semiconductor device of claim 5, wherein the forming of the plurality of trenches further comprises:
forming a sacrificial oxide layer to recover damage on a sidewall or uneven region of the epitaxial layer that occurred during an etching to form the plurality of trenches.

10. The method for manufacturing a semiconductor device of claim 5, wherein the forming of the shield insulating layer further comprises:
forming the shield insulating layer by a primary thermal oxidation or by a secondary chemical vapor deposition (CVD) after the primary thermal oxidation is performed.

11. The method for manufacturing a semiconductor device of claim 5, wherein the forming of the shield electrode further comprises:
forming the shield electrode by depositing a shield poly inside the shield insulating layer on an upper surface of the shield insulating layer;
etching the shield poly deposited on the upper surface of the shield insulating layer to a height of an upper surface of a trench via chemical mechanical polishing (CMP) or to a height of an upper surface of the epitaxial layer via blanket etching; and
etching the shield poly etched to the height of the upper surface of the trench or to the height of the upper surface of the epitaxial layer to a height at which the inter-electrode insulating layer is formed.

12. The method for manufacturing a semiconductor device of claim 5, wherein the forming of the shield electrode further comprises:
etching a portion of a side surface of the shield insulating layer to increase a width of an opening in the shield insulating layer disposed on a side of the shield electrode.

13. The method for manufacturing a semiconductor device of claim 5, wherein the forming of the inter-electrode insulating layer further comprises:
depositing a poly oxide on an upper surface of the shield insulating layer by performing a CVD on the shield electrode;
etching an upper surface of the epitaxial layer by performing a CMP, a blanket etching, or a combination of the CMP and the blanket etching; and
performing a dry etching, a wet etching, or a combination of the dry etching and the wet etching to an upper surface and a sidewall of the inter-electrode insulating layer such that the inter-electrode insulating layer etched to the upper surface of the epitaxial layer is formed in a trench.

14. The method for manufacturing a semiconductor device of claim 5, wherein the forming of the gate electrode further comprises:
depositing a gate poly on the shield insulating layer and the gate insulating layer formed on an upper surface of the epitaxial layer;
performing a CMP on the gate poly deposited on the upper surface of the epitaxial layer to the upper surface of the epitaxial layer; and
performing a recess etching to the gate poly to which the CMP is performed so that a height of the gate poly is less than a height of the upper surface of the epitaxial layer.

15. The method for manufacturing a semiconductor device of claim 5, wherein the forming of the body region further comprises:
forming the body region to have a maximum thickness on an upper surface of the epitaxial layer equal to a depth of the gate electrode formed on an upper surface of the inter-electrode insulating layer.
